# DEMANDE DE BREVET EUROPEEN

(11) **EP 1 143 573 A1**
(43) Date de publication de la demande: **10.10.2001**
(21) Numéro de dépôt: 01400896.5
(22) Date de dépôt: 06.04.2001
(51) Int. Cl.: H01R 13/646, H01R 13/74, H05K 9/00

(54) **Connecteur coaxial**

(30) Priorité: 07.04.2000 FR 0004479
(71) Demandeur: RADIALL, 93116 Rosny-Sous-Bois (FR)
(72) Inventeur: Annequin, Sébastien, 06430 Fairfield, CT (US)
(74) Mandataire: Leszczynski, André

(57) **Abrégé**

Connecteur coaxial (1) apte à être logé dans une ouverture (24) d'un panneau (21), notamment une paroi d'un boîtier métallique (20).

Ce connecteur comporte un corps tubulaire conducteur (2), une platine tubulaire conductrice (7) mobile en translation de manière coaxiale par rapport audit corps, ladite platine (7) comportant une portée continue rigide d'appui (9) contre ledit panneau (21), et au moins un organe élastique (13), notamment un ressort, agencé de manière à assurer le maintien de la platine (7) dans une position donnée par rapport au corps tubulaire (2), et à plaquer la platine (7) contre ledit panneau (21) lorsque le connecteur est assemblé avec un élément de connexion complémentaire (22).

## Description

La présente invention concerne un connecteur coaxial apte à être logé dans une ouverture d'un panneau, notamment une paroi d'un boîtier métallique.

Il est connu de limiter et/ou de supprimer la pollution électromagnétique générée par un module électronique en recouvrant celui-ci par un boîtier métallique.

Ce boîtier métallique réalise une continuité de masse autour du module de manière à constituer un blindage entre le module et l'environnement.

Dans une telle réalisation, une ouverture à travers une paroi du boîtier pour le passage d'un câble de connexion constitue une zone de fuite électromagnétique vers l'extérieur.

Afin de préserver le blindage du module électronique, il est connu d'utiliser des câbles blindés dont le blindage est relié au boîtier métallique.

Une telle mise en contact est généralement réalisée au moyen d'un connecteur comportant une platine électriquement reliée au corps du connecteur et au boîtier métallique.

Il est connu de fixer la platine sur le boîtier métallique grâce à un moyen de fixation de type vis-écrou ou au moyen de plusieurs vis.

La fixation du connecteur sur le boîtier métallique peut être encore obtenue à l'aide d'un filetage extérieur réalisé sur le connecteur de sorte que le connecteur vienne se visser sur un taraudage du boîtier.

Une telle fixation est aussi possible en introduisant en force le connecteur dans une ouverture de la paroi du boîtier.

Ces modes de fixation présentent l'avantage d'aboutir à un blindage efficace.

Toutefois, ils interdisent tout mouvement du connecteur lorsqu'il est fixé au boîtier métallique et introduisent des opérations complexes de montage et de démontage du connecteur sur le boîtier.

Dans le but de simplifier l'opération de fixation du connecteur sur le boîtier, il est possible de fixer un bracelet de blindage qui est à la fois en contact avec le connecteur et le boîtier de façon à réaliser la continuité électrique.

Ces bracelets présentent cependant un coût élevé et ne permettent que peu de liberté de déplacement du connecteur par rapport au boîtier.

La présente invention permet à la fois d'avoir un blindage efficace et une fixation relativement souple du connecteur sur le boîtier métallique.

L'invention y parvient grâce à un connecteur coaxial apte à être logé dans une ouverture d'un panneau, notamment une paroi d'un boîtier métallique, caractérisé par le fait qu'il comporte un corps tubulaire conducteur, une platine tubulaire conductrice mobile en translation de manière coaxiale par rapport audit corps, ladite platine comprenant une portée continue rigide d'appui contre ledit panneau, et au moins un organe élastique, notamment un ressort, agencé de manière à assurer le maintien de la platine dans une position donnée par rapport au corps tubulaire, et à plaquer la platine contre ledit panneau lorsque le connecteur est assemblé avec un élément de connexion complémentaire.

On assure ainsi le maintien mécanique et le contact électrique de la platine avec le panneau sans organes de maintien supplémentaires.

Le montage et le démontage de la platine sur le panneau sont ainsi particulièrement simples.

Dans une réalisation particulière, le corps et la platine présentent une symétrie de révolution.

De préférence, le corps comprend une extension de sa paroi latérale constituant un logement dans lequel la platine peut se déplacer axialement.

Dans une réalisation particulière, l'extension comporte une seconde paroi parallèle extérieurement à la paroi du corps, lesdites parois étant raccordées par une paroi radiale définissant le fond du logement.

Toujours dans une réalisation particulière, la platine comprend une partie tubulaire s'engageant dans le logement du corps, prolongée à chaque extrémité par une collerette radiale, l'une desdites collerettes étant tournée vers l'extérieur en formant la portée d'appui contre ledit panneau, l'autre collerette étant tournée vers l'intérieur et étant apte à venir en appui contre le fond du logement du corps.

Avantageusement, la partie tubulaire de la platine forme avec la paroi du corps un second logement dans lequel est logé l'organe élastique, la collerette radiale tournée vers l'intérieur définissant le fond de ce logement et servant de premier support d'appui à l'organe élastique.

De préférence, le connecteur comporte un élément rapporté solidaire du corps et agencé de manière à servir de second support d'appui à l'organe élastique.

L'élément rapporté est avantageusement de forme sensiblement tubulaire et agencé de manière à s'engager partiellement dans le logement de la platine.

Le connecteur peut comporter des moyens d'encliquetage aptes à coopérer avec des moyens correspondants d'un élément de connexion complémentaire.

Dans une réalisation particulière, l'élément de connexion complémentaire est une embase coaxiale montée sur une carte de circuit imprimé disposée dans un boîtier métallique dans l'ouverture duquel est engagé ledit connecteur.

Avantageusement, l'organe élastique est un ressort agencé de manière à ce que son effort de rappel soit inférieur à l'effort nécessaire pour désengager le connecteur de l'élément de connexion complémentaire.

De préférence, l'ouverture du panneau est réalisée de manière à ce que, lorsque le connecteur est logé dans ladite ouverture, ce dernier puisse se déplacer radialement dans ladite ouverture, la platine restant au contact du panneau.

Ainsi, il est possible de réaliser l'ouverture avec une tolérance de positionnement relativement importante.

Il suffit alors d'ajuster la position du connecteur par rapport, par exemple, à une embase sur laquelle il vient se fixer, en déplaçant radialement le connecteur dans le logement.

D'autres avantages et caractéristiques de l'invention apparaîtront à la lecture de la description qui suit, d'un exemple de réalisation nullement limitatif, en se référant au dessin annexé dans lequel :
- la figure 1 est une vue éclatée, partiellement en coupe, d'un connecteur coaxial selon l'invention,
- la figure 2 est une vue en coupe du connecteur de la figure 1 logé dans une ouverture d'une paroi d'un boîtier métallique avant fixation du connecteur sur une embase, et
- la figure 3 est une vue analogue à la figure 2 après fixation du connecteur sur l'embase.

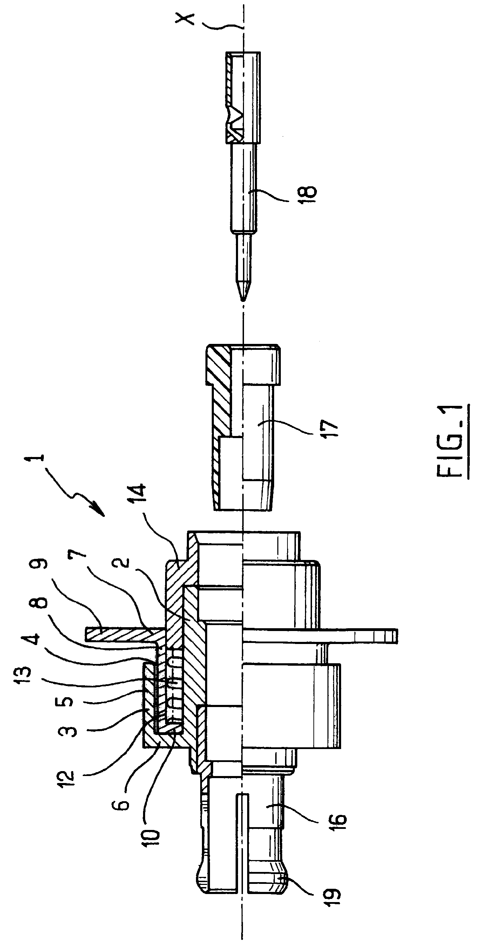

On a représenté sur la figure 1 un connecteur coaxial 1 comportant un corps 2 de forme tubulaire de révolution d'axe X.

Le corps 2 présente une extension 3 de sa paroi latérale de manière à constituer un logement 4.

L'extension 3 comporte une paroi tubulaire 5 de révolution d'axe X parallèle extérieurement à la paroi tubulaire du corps 2.

La paroi 5 et la paroi tubulaire du corps 2 sont raccordées par une paroi radiale 6 définissant le fond du logement 4.

Dans l'exemple de réalisation de la figure 1, la longueur axiale de la paroi 5 est inférieure à la longueur axiale du corps 2.

Le connecteur 1 comporte également une platine 7 mobile axialement dans le logement 4.

Le corps 2 et la platine 7 sont réalisés en métal de manière à constituer avec un boîtier métallique 20 un blindage d'un module électronique sur lequel le boîtier est monté.

Cette platine 7 comporte une partie tubulaire 8 de révolution d'axe X prolongée à chaque extrémité par une collerette radiale rigide, l'une des collerettes étant tournée vers l'extérieur formant la portée d'appui 9 contre un panneau 21 du boîtier métallique 20, l'autre collerette 10 étant tournée vers l'intérieur et venant en appui contre le fond 6 du logement 4 du corps 2. Il importe que la portée d'appui 9 soit continue, c'est-à-dire en particulier ne comporte pas de fente ou autre discontinuité, afin d'assurer une fonction de blindage électromagnétique efficace.

D'autre part, la platine 7 définit entre sa paroi tubulaire 8, la collerette radiale 10 et la paroi tubulaire du corps 2 un logement 12 dans lequel est logé un ressort 13, la collerette radiale 10 formant un premier support d'appui pour ledit ressort 13.

Ce logement 12 présente une ouverture s'étendant radialement et dans laquelle on introduit partiellement un élément rapporté 14 de forme tubulaire.

Une paroi radiale de cet élément 14 ferme le logement 12 et définit un second support d'appui au ressort 13.

L'élément rapporté 14 est réalisé en métal et est fixé au corps 2, par exemple par soudage ou emmanchement à force.

Le ressort 13 est agencé de manière à ce que, lorsqu'aucune contrainte extérieure n'est exercée sur la platine 7, ce dernier plaque la collerette radiale 10 de la platine 7 contre le fond du logement 4, c'est-à-dire contre la paroi radiale 6.

D'autre part, le connecteur 1 comporte une tubulure en métal 16 d'axe X dont une extrémité libre forme une protubérance 19 de forme annulaire dont on décrira la fonction ultérieurement.

Une tubulure isolante 17 comportant un conducteur central 18 est introduite à l'intérieur du corps 2.

Le corps 2, la platine 7, l'élément rapporté 14 et la tubulure 16 forment un conducteur de masse apte à s'engager sur une embase coaxiale 22 montée sur une carte de circuit imprimé 23 à l'intérieur du boîtier 20.

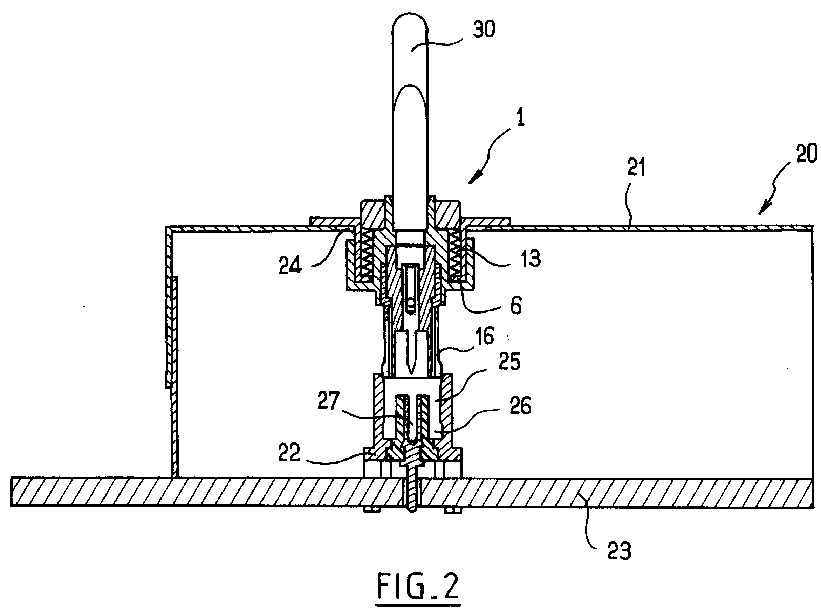

Comme cela est représenté à la figure 2, le connecteur coaxial 1 est logé dans une ouverture 24 d'un panneau 21 d'un boîtier métallique 20 destiné au blindage d'un module électronique défini notamment par une carte de circuit imprimé 23.

Le diamètre de l'ouverture 24 est supérieur au diamètre de la partie tubulaire du corps 2.

Ainsi, le connecteur 1 peut se déplacer radialement dans l'ouverture 24, la collerette radiale 9 restant en contact avec la paroi 21 du boîtier 20.

De fait, il n'est plus nécessaire de positionner de manière précise l'embase 25 par rapport à l'ouverture 21 du boîtier métallique 20.

La figure 2 représente le connecteur 1 mis en place dans le logement 24 sans être engagé dans l'embase 22.

Le connecteur 1 est relié à un câble coaxial 30 muni d'un blindage mis en contact avec le boîtier 20 par l'intermédiaire de la platine 7.

L'embase 22 comporte un logement 25 dont la partie inférieure présente à l'intérieur une cavité de forme annulaire 26.

L'embase 22 comporte également un logement 27 apte à recevoir le conducteur central 18.

La fixation du connecteur 1 sur l'embase 22 est réalisée en exerçant une pression sur une partie du connecteur, par exemple sur l'élément rapporté 14, de manière à engager la protubérance 19 de la partie tubulaire 16 dans la cavité 26 de l'embase 22.

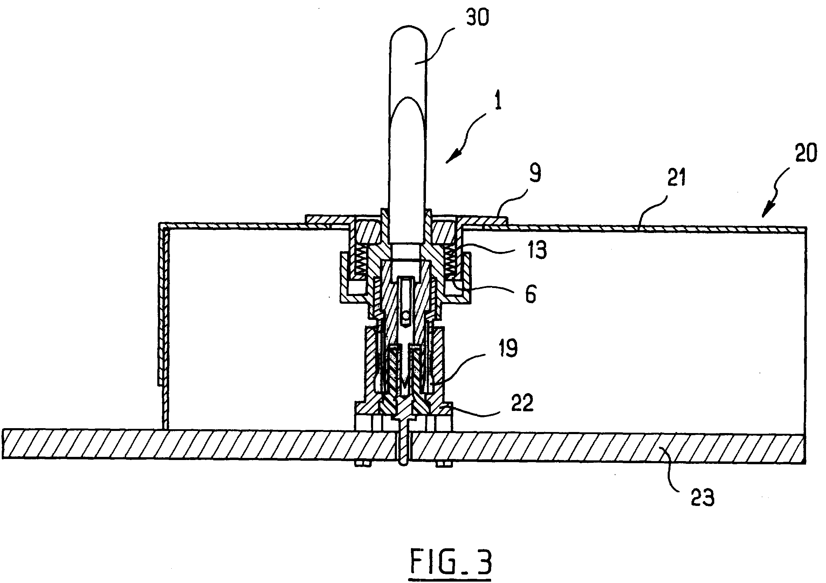

Ainsi, comme cela est représenté à la figure 3, le ressort 13 se comprime et exerce une contrainte axiale sur la collerette radiale 10 de manière à maintenir la collerette radiale 9 en contact avec le panneau 21 du boîtier 20.

Le ressort est choisi de façon à ce que, lorsque le connecteur 1 est fixé sur l'embase 22, il exerce une contrainte sur la platine 7 inférieure à la contrainte nécessaire pour désengager le connecteur 1 de l'embase 22.

Ainsi, la fixation du connecteur 1 sur l'embase 22 est particulièrement simple, cette fixation étant assurée par l'encliquetage de ces deux parties.

Bien que l'invention ait été décrite en liaison avec un mode de réalisation particulier, elle n'y ait nullement limitée et l'on peut lui apporter toute modification souhaitable sans sortir de sa portée telle que définie par les revendications.

## Revendications

1. Connecteur coaxial (1) apte à être logé dans une ouverture (24) d'un panneau (21), notamment une paroi d'un boîtier métallique (20), **caractérisé par** le fait qu'il comporte un corps tubulaire conducteur (2), une platine tubulaire conductrice (7) mobile en translation de manière coaxiale par rapport audit corps, ladite platine (7) comportant une portée continue rigide d'appui (9) contre ledit panneau (21), et au moins un organe élastique (13), notamment un ressort, agencé de manière à assurer le maintien de la platine (7) dans une position donnée par rapport au corps tubulaire (2), et à plaquer la platine (7) contre ledit panneau (21) lorsque le connecteur est assemblé avec un élément de connexion complémentaire (22).

2. Connecteur selon la revendication précédente, **caractérisé par** le fait que le corps (2) et la platine (7) présentent une symétrie de révolution.

3. Connecteur selon l'une quelconque des revendications précédentes, **caractérisé par** le fait que le corps (2) comprend une extension (3) de sa paroi latérale constituant un logement (4) dans lequel la platine (7) peut se déplacer axialement.

4. Connecteur selon la revendication précédente, **caractérisé par** le fait que l'extension (3) comporte une seconde paroi (5) parallèle extérieurement à la paroi du corps (2), lesdites parois étant raccordées par une paroi radiale (6) définissant le fond du logement (4).

5. Connecteur selon l'une quelconque des revendications 3 et 4, **caractérisé par** le fait que la platine (7) comporte une partie tubulaire (8) s'engageant dans le logement (4) du corps, prolongée à chaque extrémité par une collerette radiale rigide, l'une desdites collerettes étant tournée vers l'extérieur formant la portée d'appui (9) sur ledit panneau (21), l'autre collerette (10) étant tournée vers l'intérieur et étant apte à venir en appui contre le fond du logement (4) du corps.

6. Connecteur selon l'une quelconque des revendications 3 à 5, **caractérisé par** le fait que la partie tubulaire (8) de la platine forme avec la paroi du corps (2) un second logement (12) dans lequel est logé l'organe élastique (13), la collerette radiale (10) tournée vers l'intérieur définissant une paroi de fond de ce logement (12) et servant de premier support d'appui à l'organe élastique (13).

7. Connecteur selon la revendication précédente, **caractérisé par** le fait qu'il comprend un élément rapporté (14) solidaire du corps (2) et agencé de manière à définir un second support d'appui à l'organe élastique (13).

8. Connecteur selon la revendication précédente, **caractérisé par** le fait que l'élément rapporté (14) est de forme sensiblement tubulaire et agencé de manière à s'engager partiellement dans le logement (12) de la platine (7).

9. Connecteur selon l'une quelconque des revendications précédentes, **caractérisé par** le fait qu'il comporte des moyens d'encliquetage (19) aptes à coopérer avec des moyens correspondants d'un élément de connexion complémentaire (22).

10. Connecteur selon la revendication précédente, **caractérisé par** le fait que l'élément de connexion complémentaire est une embase coaxiale (22) montée sur une carte de circuit imprimé (26) disposée dans un boîtier métallique (20) dans l'ouverture (24) duquel est engagé ledit connecteur (1).

11. Connecteur selon l'une quelconque des revendications 9 et 10, **caractérisé par** le fait que l'organe élastique (13) est un ressort agencé de manière à ce que son effort de rappel soit inférieur à l'effort nécessaire pour désengager le connecteur (1) de l'élément de connexion complémentaire (22).

12. Connecteur selon l'une quelconque des revendications précédentes, **caractérisé par** le fait que l'ouverture (24) du panneau (21) est réalisée de manière à ce que lorsque le connecteur (1) est logé dans ladite ouverture (24), ce dernier puisse se déplacer radialement dans ladite ouverture, la platine (7) restant au contact du panneau (21).
